# EUROPEAN PATENT SPECIFICATION

(11) **EP 4 425 199 B1**
(45) Date of publication and mention of the grant of the patent: **12.11.2025**
(21) Application number: 22919058.2
(22) Date of filing: 19.12.2022
(51) Int. Cl.: G01R 31/367, G01R 31/392, G01R 31/396

(54) **BATTERY DATA MANAGEMENT APPARATUS AND OPERATING METHOD THEREOF**
BATTERIEDATENVERWALTUNGSVORRICHTUNG UND BETRIEBSVERFAHREN
DISPOSITIF DE GESTION DE DONNÉES DE BATTERIE ET PROCÉDÉ DE FONCTIONNEMENT

(30) Priority: 07.01.2022 KR 20220003019
(43) Date of publication of application: 04.09.2024
(73) Proprietor: LG Energy Solution, Ltd., Seoul 07335 (KR)
(72) Inventor: SUN, Ju Young, Daejeon 34122 (KR); KANG, Ho Seok, Daejeon 34122 (KR); KIM, Deuk Joong, Daejeon 34122 (KR)
(74) Representative: Plasseraud IP
(86) International application number: PCT/KR2022/020750
(87) International publication number: WO 2023/132521

(56) References cited:
- CN-A- 105 789 716
- CN-A- 111 900 498
- KR-A- 20110 074 207
- KR-A- 20150 020 958
- KR-A- 20200 136 733
- US-A1- 2015 323 608
- US-A1- 2018 074 135
- US-A1- 2019 310 319
- US-A1- 2020 081 065

## Description

### [TECHNICAL FIELD]

### CROSS-REFERENCE TO RELATED APPLICATION

This application claims priority to and the benefit of Korean Patent Application No. 10-2022-0003019 filed in the Korean Intellectual Property Office on January 7, 2022.

### TECHNICAL FIELD

Embodiments disclosed herein relate to a battery data management apparatus and an operating method thereof.

### [BACKGROUND ART]

An electric vehicle or an energy storage system (ESS) charges a plurality of batteries connected in series and/or in parallel and drives a motor with charged voltage to obtain power. The battery may have heat generated therein by chemical reaction occurring in a process of charging and discharging electricity, and the heat may impair performance and lifetime of the battery. Thus, a battery management system (BMS) may diagnose a state of the battery by monitoring battery data including temperature, voltage, and current of the battery.

A storage storing such large-volume battery data needs to efficiently manage accumulated battery data depending on importance and usage of the battery data. This is because the analysis of a cause for battery abnormality may occur depending on management method and type. Accordingly, there is a need for a battery data management apparatus and method capable of efficiently managing a storage that stores battery data.

Document CN 111 900 498 A discloses a method for storing and retrieving fault information of a battery management system of the related art.

Document US 2015/323608 A1 discloses an intelligent battery sensor for a vehicle which detects an overcurrent module generating an abnormal overcurrent within a vehicle.

### [DISCLOSURE]

### [TECHNICAL PROBLEM]

Embodiments disclosed herein aim to provide a battery data management apparatus and an operating method thereof, in which battery data may be efficiently managed by separating a storage that stores the battery data.

Technical problems of the embodiments disclosed herein are not limited to the above-described technical problems, and other unmentioned technical problems would be clearly understood by one of ordinary skill in the art from the following description.

### [TECHNICAL SOLUTION]

A battery data management apparatus according to an embodiment disclosed herein is defined in the appended claims.

An operating method of a battery data management apparatus according to an embodiment is also provided.

### [ADVANTAGEOUS EFFECTS]

With a battery data management apparatus and an operating method thereof according to an embodiment disclosed herein, battery data may be efficiently managed by separating a storage that stores the battery data.

### [DESCRIPTION OF DRAWINGS]

FIG. 1 is a view schematically showing a configuration of a battery pack to which a battery data management apparatus according to an embodiment disclosed herein is applied.
FIG. 2 is a view showing a configuration of a battery data management apparatus according to an embodiment disclosed herein.
FIG. 3 is a view for describing in detail an overall operation of a battery data management apparatus according to an embodiment disclosed herein.
FIG. 4 is a view for describing in detail an overall operation of a battery data management apparatus according to another embodiment disclosed herein.
FIG. 5 is a flowchart of an operating method of a battery management apparatus according to an embodiment disclosed herein.
FIG. 6 is a block diagram showing a hardware configuration of a computing system for performing an operating method of a battery data management apparatus, according to an embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

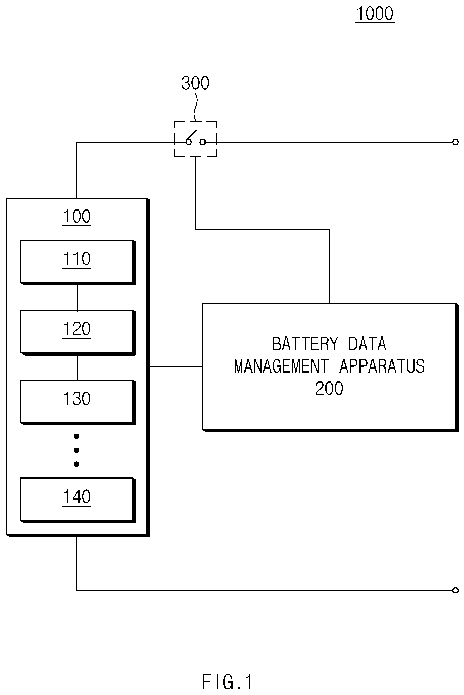

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV), but is not limited thereto.

The plurality of battery cells 110, 120, 130, and 140 may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery management apparatus 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

In addition, the battery management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery management apparatus 200, which are not shown, may be additionally installed in the battery module 100, a charging/discharging path, any position of the battery module 100, etc. The battery management apparatus 200 may calculate a parameter indicating a state of the battery module 100, e.g., a state of charge (SoC), a state of health (SoH) etc., based on a measurement value such as monitored voltage, current, temperature, etc.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000.

The battery management apparatus 200 may calculate a cell balancing time of each of the plurality of battery cells 110, 120, 130, and 140. Herein, the cell balancing time may be defined as a time required for balancing of the battery cell. For example, the battery management apparatus 200 may calculate a cell balancing time based on an SoC, a battery capacity, and a balancing efficiency of each of the plurality of battery cells 110, 120, 130, and 140.

The battery management apparatus 200 may include a power data management apparatus 210.

The battery data management apparatus 210 may obtain temperature and voltage measurement values of the plurality of batteries, and SoC and SoH parameters derived therefrom as data. The battery data management apparatus 210 may diagnose whether a battery is abnormal based on the obtained data. The battery data management apparatus 210 may classify and store battery data based on the obtained diagnosis result of whether the plurality of batteries are abnormal.

The battery data management apparatus 210 may transmit battery data obtained from the plurality of batteries to an external server to analyze and manage the battery data by using the external server having rich computing resources. Moreover, the battery data management apparatus 210 may precisely analyze an abnormal phenomenon of the battery through the external server to diagnose whether the battery is in an abnormal state in real time.

In addition, the battery data management apparatus 210 may analyze and manage the battery data obtained from the plurality of batteries by using internal components having rich computing resources. The battery data management apparatus 210 may also precisely analyze an abnormal phenomenon of the battery through the internal components to diagnose whether the plurality of batteries are in abnormal states.

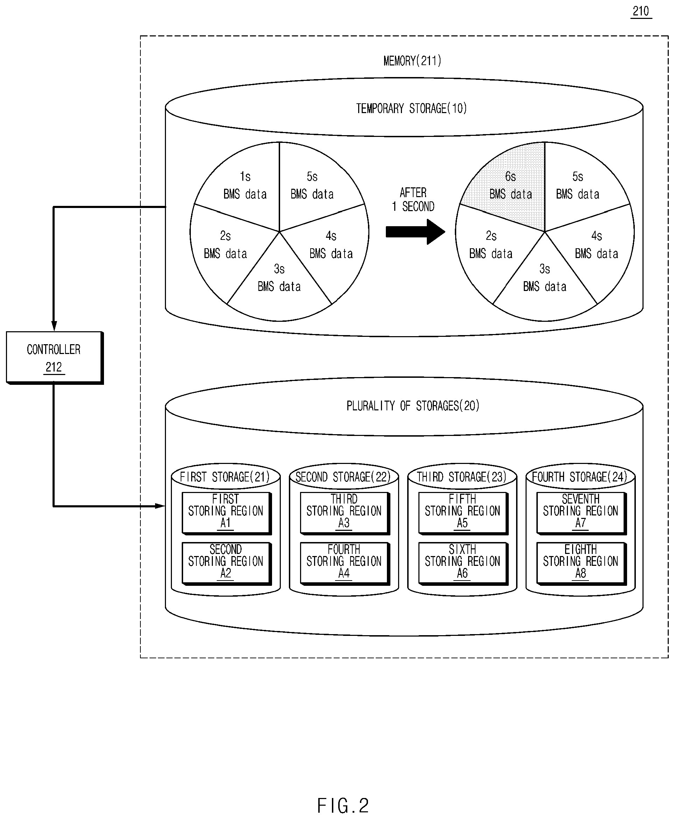

FIG. 2 is a block diagram showing a configuration of a battery data management apparatus according to an embodiment disclosed herein.

Hereinbelow, a configuration of the battery data management apparatus 210 will be described in detail with reference to FIG. 2.

First, referring to FIG. 2, the battery data management apparatus 210 may include a memory 211 and a controller 212.

The memory 211 may include a temporary storage 10 in which battery data of the battery data management apparatus obtained may be temporarily stored and a plurality of storages 20 in which the battery data may be classified and stored.

The temporary storage 10 may include a circular queue capable of storing the battery data at regular intervals. The queue may be defined as a data structure in which a continuous space is allocated such that first input data is output first. According to an embodiment, the circular queue may include 5 buffers. The buffer has a limited size of data that may be stored, and thus may temporarily store data continuously. The temporary storage 10 may temporarily store battery data continuously by using the circular queue including the 5 buffers.

The temporary storage 10 may temporarily store the battery data at regular time intervals. According to an embodiment, the temporary storage 10 may update the battery data every 1 second (every second) by using the circular queue including the 5 buffers.

The controller 212 may analyze the battery data based on a regular time interval. The controller 212 may analyze whether a battery is abnormal, based on the battery data stored in the temporary storage 10. More specifically, the controller 212 may analyze whether a battery is abnormal, based on voltage, current, and temperature data of the plurality of batteries. Herein, abnormality may be defined as a feature or a parameter of a component inside the system deviating from a prescribed condition by an allowable deviation or more.

For example, the controller 212 may diagnose that a battery is in an abnormal state when battery data including at least any one of voltage, current, temperature, and diagnosis information of a battery from time (t-5) to time t, stored in the temporary storage 10, deviates from previously stored conditions or preset conditions by an allowable deviation or more.

The controller 212 may further obtain and store battery data stored in the temporary storage 10 after an elapse of a particular time when diagnosing that the battery is in the abnormal state, based on the battery data stored in the temporary storage 10. For example, when diagnosing that the battery is in the abnormal state based on the battery data from the time (t-5) to the time t, stored in the temporary storage 10, the controller 212 may further obtain battery data from time (t+1) to time (t+5), stored in the temporary storage 10, after an elapse of 5 seconds, thus storing battery data generated for a total of 10 seconds.

For example, the controller 212 may store battery data for 5 seconds up to an abnormality diagnosis occurrence time, and then further store battery data after an elapse of 5 seconds, thus storing a battery data history for 10 seconds before and after the abnormality diagnosis occurrence time. Thus, the controller 212 may identify a change in the battery data for 10 seconds before and after the abnormality diagnosis occurrence time.

The controller 212 may determine an abnormality level of the battery based on whether the battery is abnormal. For example, the controller 212 may determine whether abnormality occurs in the battery management apparatus 200, and determine an abnormality level of the occurring abnormality.

For example, the abnormality level may be determined according to severity, exposure, and controllability of damage caused by malfunction of vehicle parts through vehicle-level risk source analysis and risk assessment. For example, the abnormality level may be classified into four levels such as Fault2, Fault1, Warning, and Alarm. The abnormality level may define Fault2 as the highest risk level and Alarm as the lowest risk criterion. For example, when overvoltage or undervoltage occurs in a battery cell due to occurrence of a short-circuit in a battery module control cable of the BMS or a battery module diagnosis cable, such that a temperature of a battery rises and thus the risk of battery ignition is expected, then the abnormality level of the battery may be the Fault2 level.

The controller may classify and store the battery data in the plurality of storages 20, based on the abnormality level of the battery. For example, the plurality of storages 20 may include a first storage 21, a second storage 22, a third storage 23, and a fourth storage 24. The first storage 22, the second storage 23, the third storage 24, and the fourth storage 24 may be separated physically or programmatically. For example, the first storage 21 may store battery data corresponding to Fault2 that is the abnormality level of the battery. The second storage 22 may store battery data corresponding to Fault1 that is the abnormality level of the battery. The third storage 23 may store battery data corresponding to Warning that is the abnormality level of the battery. The fourth storage 24 may store battery data corresponding to Alarm that is the abnormality level of the battery.

Herein, each of the plurality of storages 20 may include a plurality of storing regions. Based on priorities of a plurality of storing regions of any one of the plurality of storages 20, the controller 212 may store battery data in any one of the plurality of storing regions. More specifically, the first storage 21 may include a first storing region A1 and a second storing region A2. The second storage 22 may include a third storing region A3 and a four storing region A4. The third storage 23 may include a fifth storing region A5 and a sixth storing region A6. The fourth storage 24 may include a seventh storing region A7 and an eighth storing region A8.

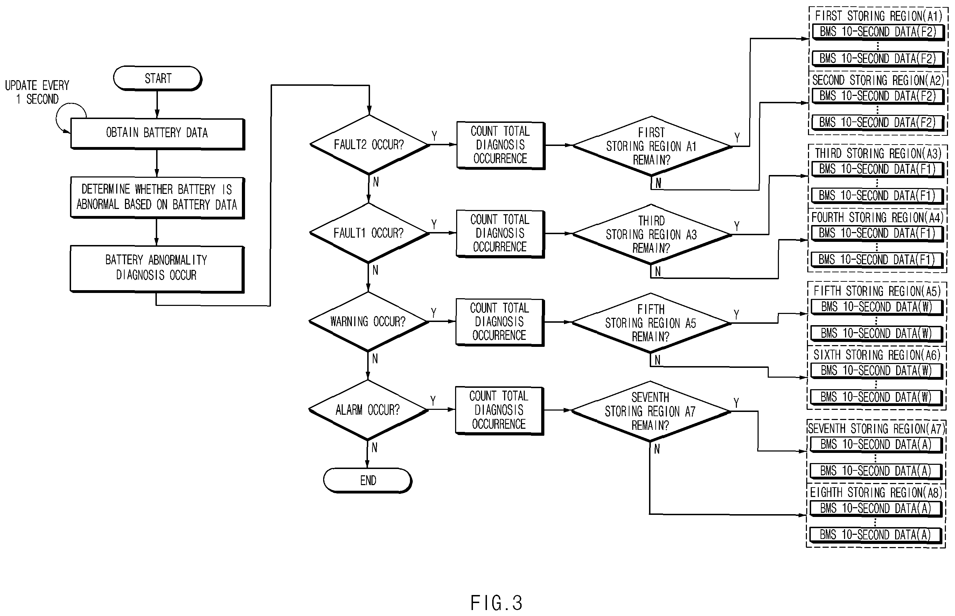

FIG. 3 is a view for describing in detail an overall operation of a battery data management apparatus according to an embodiment disclosed herein.

Referring to FIG. 3, the controller 212 is configured to determine whether the battery corresponds to an abnormality level in descending order of risk level of the abnormality level. For example, the controller 212 may determine whether the battery corresponds to the abnormality level in order of whether the battery corresponds to the Fault 2 level, whether the battery corresponds to the Fault1 level, whether the battery corresponds to the Warning level, and then whether the battery corresponds to the Alarm level.

When determining the abnormality level of the battery, the controller 212 may classify and store battery data in any one of the plurality of storages, which corresponds to the abnormality level of the battery.

For example, when the abnormality level of the battery corresponds to Fault2, the controller 212 may determine whether a storage space exists in the first storing region A1 of the first storage 21. The controller 212 may store the battery data in the second storing region A2 when there is no storage space in the first storing region A1 of the first storage 21.

For example, when the abnormality level of the battery corresponds to Fault1, the controller 212 may determine whether a storage space exists in the third storing region A3 of the second storage 22. The controller 212 may store the battery data in the fourth storing region A4 when there is no storage space in the third storing region A3 of the second storage 22.

For example, when the abnormality level of the battery corresponds to Warning, the controller 212 may determine whether a storage space exists in the fifth storing region A5 of the third storage 23. The controller 212 may store the battery data in the sixth storing region A6 when there is no storage space in the fifth storing region A5 of the third storage 23.

For example, when the abnormality level of the battery corresponds to Alarm, the controller 212 may determine whether a storage space exists in the seventh storing region A7 of the fourth storage 24. The controller 212 may store the battery data in the eighth storing region A8 when there is no storage space in the seventh storing region A7 of the fourth storage 24.

Herein, the first storing region A1, the third storing region A3, the fifth storing region A5, and the seventh storing region A7 may be defined as battery data storage spaces for identifying an initial abnormality diagnosis occurrence history, and the second storing region A2, the fourth storing region A4, the sixth storing region A6, and the eighth storing region A8 may be defined as battery data storage spaces for identifying a recent abnormality diagnosis occurrence history.

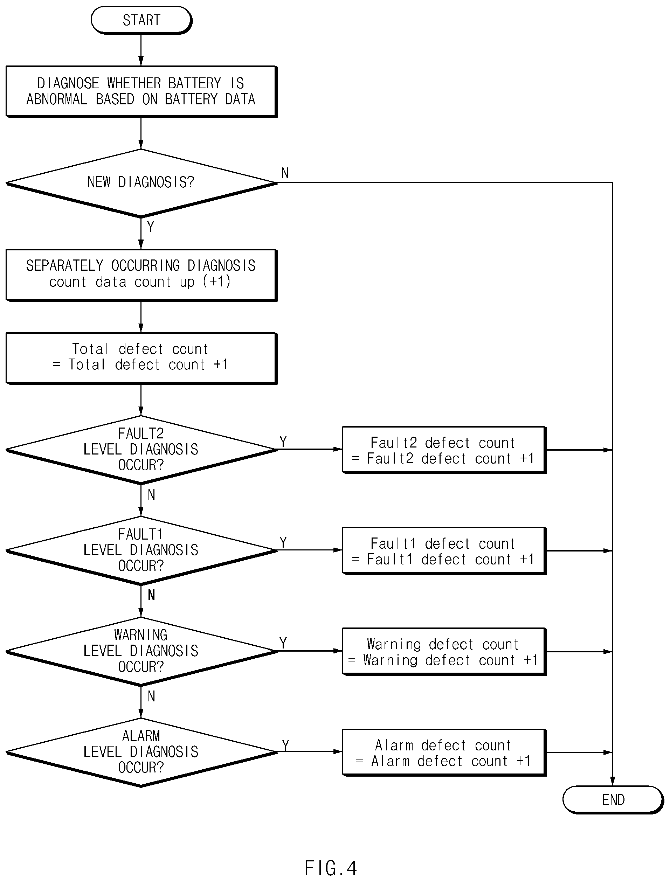

FIG. 4 is a view for describing in detail an overall operation of a battery data management apparatus according to another embodiment disclosed herein.

Referring to FIG. 4, the controller 212 may allocate count data to each abnormality level of the battery. When determining an abnormality level of the battery, the controller 212 may allocate count data to the corresponding abnormality level. That is, when determining the abnormality level of the battery, the controller 212 may increase count data corresponding to determination of the corresponding abnormality level.

The controller 212 may classify and store battery data in a plurality of storing regions of any one of the plurality of storages 20, based on the count data of the abnormality level, increased when determining the abnormality level of the battery.

For example, the controller 212 may store the battery data in the first storing region A1 when the abnormality level of the battery is Fault2 and a count value of the Fault2 level is within 10. The controller 212 may store the battery data in the second storing region A2 when the abnormality level of the battery is Fault2 and a count value of the Fault2 level exceeds 10.

For example, the controller 212 may store the battery data in the third storing region A3 when the abnormality level of the battery is Fault1 and a count value of the Fault1 level is within 10. The controller 212 may store the battery data in the fourth storing region A4 when the abnormality level of the battery is Fault1 and a count value of the Fault1 level exceeds 10.

For example, the controller 212 may store the battery data in the fifth storing region A5 when the abnormality level of the battery is Warning and a count value of the Warning level is within 10. The controller 212 may store the battery data in the sixth storing region A6 when the abnormality level of the battery is Warning and a count value of the Warning level exceeds 10.

For example, the controller 212 may store the battery data in the seventh storing region A7 when the abnormality level of the battery is Alarm and a count value of the Alarm level is within 10. The controller 212 may store the battery data in the eighth storing region A8 when the abnormality level of the battery is Alarm and a count value of the Alarm level exceeds 10.

Herein, a reference count value may be changed based on a size of a storing region, a size of a storage space, or a size of the memory 211.

As described above, with the battery data management apparatus 210 according to an embodiment disclosed herein, it is possible to efficiently manage battery data in several storages by separating a battery data storage.

The battery data management apparatus 210 may classify and manage battery data according to an abnormality level of a battery to separately manage battery data of high importance, thereby making it easy to track a cause for abnormality of the battery.

Moreover, it is possible to solve a problem that battery data of an abnormality level of no importance occupies a storing region of battery data corresponding to an abnormality of high importance due to frequency abnormality diagnosis when a storing region is separated for each abnormality level and a battery data storing region is not left.

The battery data management apparatus 210 may use a circular queue data structure including a plurality of buffers in a structure that stores only battery data obtained for 1 second when battery abnormality diagnosis occurs, thereby storing and analyzing battery data for several seconds before and after a battery abnormality diagnosis occurrence time and thus analyzing a change in battery data.

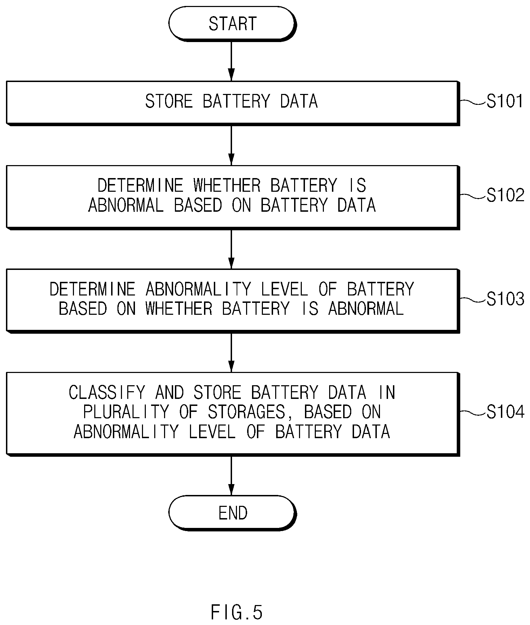

FIG. 5 is a flowchart of an operating method of a battery management apparatus according to an embodiment disclosed herein. Hereinbelow, an operating method of the battery data management apparatus 210 will be described with reference to FIGS. 1 to 4.

The battery data management apparatus 210 may be substantially the same as the battery data management apparatus 210 described with reference to FIGS. 1 to 4, and thus will be briefly described to avoid redundant description.

Referring to FIG. 5, the operating method of the battery data management apparatus may include operation S101 of storing battery data, operation S102 of determining whether a battery is abnormal based on the battery data, operation S103 of determining an abnormality level of the battery based on whether the battery is abnormal, and operation S104 of classifying and storing the battery data in a plurality of storages.

Hereinbelow, operations S101 through S104 will be described in detail.

In operation S101, the temporary storage 10 of the memory 211 may include a circular queue capable of storing the battery data at regular intervals. In operation S101, according to an embodiment, the circular queue may include 5 buffers. In operation S101, the temporary storage 10 of the memory 211 may temporarily store battery data by using the circular queue including the 5 buffers.

In operation S101, the temporary storage 10 of the memory 211 may temporarily store the battery data at regular time intervals. In operation S101, according to an embodiment, the temporary storage 10 of the memory 211 may update the battery data every 1 second (every second) by using the circular queue including the 5 buffers.

In operation S102, the controller 212 may analyze the battery data based on a regular time interval. In operation S102, the controller 212 may analyze whether the battery is abnormal, based on the battery data stored in the temporary storage 10 of the memory 211. In operation S102, more specifically, the controller 212 may analyze whether the battery is abnormal, based on voltage, current, and temperature data of the plurality of batteries.

In operation S102, for example, the controller 212 may diagnose that a battery is in an abnormal state when battery data including at least any one of voltage, current, temperature, and diagnosis information of a battery from time (t-5) to time t, stored in the temporary storage 10, deviates from previously stored conditions or preset conditions by an allowable deviation or more.

In operation S103, the controller 212 may further obtain and store battery data stored in the temporary storage 10 after an elapse of a particular time when diagnosing that the battery is in the abnormal state, based on the battery data stored in the temporary storage 10. In operation S103, for example, when diagnosing that the battery is in the abnormal state based on the battery data from the time (t-5) to the time t, stored in the temporary storage 10, the controller 212 may further obtain battery data from time (t+1) to time (t+5), stored in the temporary storage 10, after an elapse of 5 seconds, thus storing battery data generated for a total of 10 seconds.

In operation S103, for example, the controller 212 may store battery data for 5 seconds up to an abnormality diagnosis occurrence time, and then further store battery data after an elapse of 5 seconds, thus storing a battery data history for 10 seconds before and after the abnormality diagnosis occurrence time. Thus, the controller 212 may identify a change in the battery data for 10 seconds before and after the abnormality diagnosis occurrence time.

In operation S103, the controller 212 may determine an abnormality level of the battery when diagnosing that the battery is in the abnormal state based on the battery data. For example, the controller 212 may determine whether abnormality occurs in the battery management apparatus 200, and determine an abnormality level of the occurring abnormality.

In operation S103, the controller 212 is configured to determine whether the battery corresponds to an abnormality level in descending order of risk level of the abnormality level. For example, the controller 212 may determine whether the battery corresponds to the abnormality level in order of whether the battery data corresponds to the Fault 2 level, whether the battery data corresponds to the Fault1 level, whether the battery data corresponds to the Warning level, and then whether the battery data corresponds to the Alarm level.

In operation S103, the controller 212 may allocate count data to each abnormality level of the battery. In operation S103, when determining an abnormality level of the battery, the controller 212 may allocate count data to the corresponding abnormality level. In operation S103, that is, when determining the abnormality level of the battery, the controller 212 may increase count data corresponding to determination of the corresponding abnormality level.

In operation S104, the controller 212 may monitor abnormality detection information including the abnormality level of the battery and classify and store the battery data according to the abnormality level. In operation S104, more specifically, the controller 212 may store the battery data in any one of the plurality of storages 20 corresponding to the abnormality level of the battery.

In operation S104, when diagnosing that the battery is in the abnormal state, the controller 212 may obtain battery data stored in a plurality of circular queues and battery data stored after an elapse of a specific period in the plurality of circular queues and classify and store the battery data in the plurality of storages 20.

Herein, each of the plurality of storages 20 may include a plurality of storing regions. In operation S104, based on priorities of a plurality of storing regions of any one of the plurality of storages 20, the controller 212 may store battery data in any one of the plurality of storing regions. More specifically, the first storage 21 may include a first storing region A1 and a second storing region A2. The second storage 22 may include a third storing region A3 and a four storing region A4. The third storage 23 may include a fifth storing region A5 and a sixth storing region A6. The fourth storage 24 may include a seventh storing region A7 and an eighth storing region A8.

In operation S104, for example, when the abnormality level of the battery corresponds to Fault2, the controller 212 may determine whether a storage space exists in the first storing region A1 of the first storage 21. The controller 212 may store the battery data in the second storing region A2 when there is no storage space in the first storing region A1 of the first storage 21.

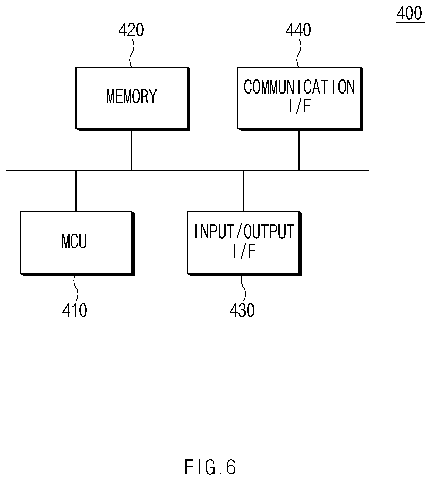

FIG. 6 is a block diagram showing a hardware configuration of a computing system for performing an operating method of a battery data management apparatus, according to an embodiment disclosed herein.

Referring to FIG. 6, a computing system 400 according to an embodiment disclosed herein may include an MCU 410, a memory 420, an input/output I/F 430, and a communication I/F 440.

The MCU 410 may be a broker that executes various programs (e.g., a program for monitoring data of a battery, etc.) stored in the memory 420, processes various data through these programs, and performs the above-described functions of the battery data management apparatus 210 shown in FIG. 1.

The memory 420 may store various programs regarding operations of the computing system. Moreover, the memory 420 may store operation data of computing system.

The memory 420 may be provided in plural, depending on a need. The memory 420 may be volatile memory or non-volatile memory. For the memory 420 as the volatile memory, random access memory (RAM), dynamic RAM (DRAM), static RAM (SRAM), etc., may be used. For the memory 420 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 420 are merely examples and are not limited thereto.

The input/output I/F 430 may provide an interface for transmitting and receiving data by connecting an input device (not shown) such as a keyboard, a mouse, a touch panel, etc., and an output device such as a display (not shown), etc., to the MCU 410.

The communication I/F 440, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 440.

The above description is merely illustrative of the technical idea of the present disclosure, and various modifications and variations will be possible without departing from the essential characteristics of the present disclosure by those of ordinary skill in the art to which the present disclosure pertains.

.

## Claims

1. A battery data management apparatus (200) comprising:
a controller (212) configured to determine whether a battery is abnormal based on battery data, determine an abnormality level of the battery based on whether the battery is abnormal, and classify and store the battery data in a plurality of storages (20), based on the abnormality level of the battery; and
a memory (211) comprising the plurality of storages (20) and a temporary storage (10) temporarily storing the battery data,
**characterized in that** the controller (212) is further configured to determine whether the battery corresponds to an abnormal level in descending order of risk level of the abnormality level.

2. The battery data management apparatus of claim 1, wherein the controller (212) is further configured to store the battery data in any one of the plurality of storages (10), which corresponds to the abnormality level of the battery.

3. The battery data management apparatus of claim 1, wherein the controller (212) is further configured to, based on priorities of a plurality of storing regions of any one of the plurality of storages (20), store the battery data in any one of the plurality of storing regions.

4. The battery data management apparatus of claim 1, wherein the controller (212) is further configured to, when diagnosing that the battery is in an abnormal state, obtain battery data stored in the temporary storage (10) at a time when the battery is diagnosed as being in the abnormal state, and battery data stored in the temporary storage (10) after an elapse of a specific period, and classify and store the battery data in the plurality of storages (20).

5. The battery data management apparatus of claim 1, wherein the memory (211) stores the battery data at regular intervals in a circular queue of the temporary storage (10).

6. The battery data management apparatus of claim 1, wherein the battery data comprises at least any one of voltage, current, temperature, and diagnosis information of the battery.

7. An operating method of a battery data management apparatus (200), the operating method comprising:
temporarily storing battery data (S101);
determining whether the battery is abnormal, based on the battery data (S102);
determining an abnormal level of the battery based on whether the battery is abnormal (S103); and
classifying and storing the battery data in a plurality of storages (20), based on the abnormal level of the battery (S104),
**characterized in that** the determining of the abnormal level of the battery based on whether the battery is abnormal comprises determining whether the battery corresponds to an abnormal level in descending order of risk level of the abnormality level.

8. The operating method of claim 7, wherein the determining of the abnormal level of the battery based on whether the battery is abnormal comprises storing the battery data in any one of the plurality of storages (20), which corresponds to the abnormality level of the battery.

9. The operating method of claim 7, wherein the classifying and storing of the battery data in the plurality of storages (20), based on the abnormal level of the battery, comprises, based on priorities of a plurality of storing regions of any one of the plurality of storages, storing the battery data in any one of the plurality of storing regions.

10. The operating method of claim 7, wherein the temporarily storing of the battery data comprises, when diagnosing that the battery is in an abnormal state, obtaining battery data stored in the temporary storage (10) at a time when the battery is diagnosed as being in the abnormal state, and battery data stored in the temporary storage after an elapse of a specific period, and classifying and storing the battery data in the plurality of storages (20).

11. The operating method of claim 7, wherein the temporarily storing of the battery data comprises storing the battery data at regular intervals in a circular queue of the temporary storage (10).

## Patentansprüche

1. Batteriedatenverwaltungsvorrichtung (200), umfassend:
eine Steuereinrichtung (212), welche dazu eingerichtet ist, auf Grundlage von Batteriedaten zu bestimmen, ob eine Batterie abnormal ist, auf Grundlage davon, ob die Batterie abnormal ist, einen Abnormalitätsgrad der Batterie zu bestimmen und auf Grundlage des Abnormalitätsgrads der Batterie Batteriedaten zu klassifizieren und in einer Mehrzahl von Speichern (20) zu speichern; und
einen Speicher (211), welcher die Mehrzahl von Speichern (20) und einen temporären Speicher (10) umfasst, der die Batteriedaten temporär speichert,
**dadurch gekennzeichnet, dass** die Steuereinrichtung (212) ferner dazu eingerichtet ist, zu bestimmen, ob die Batterie einem Abnormalitätsgrad entspricht, in einer absteigenden Reihenfolge eines Risikograds des Abnormalitätsgrads.

2. Batteriedatenverwaltungsvorrichtung nach Anspruch 1, wobei die Steuereinrichtung (212) ferner dazu eingerichtet ist, die Batteriedaten in jeglichem der Mehrzahl von Speichern (10) zu speichern, welcher dem Abnormalitätsgrad der Batterie entspricht.

3. Batteriedatenverwaltungsvorrichtung nach Anspruch 1, wobei die Steuereinrichtung (212) ferner dazu eingerichtet ist, auf Grundlage von Prioritäten einer Mehrzahl von Speicherbereichen von jeglichem der Mehrzahl von Speichern (20) die Batteriedaten in jeglichem der Mehrzahl von Speicherbereichen zu speichern.

4. Batteriedatenverwaltungsvorrichtung nach Anspruch 1, wobei die Steuereinrichtung (212) ferner dazu eingerichtet ist, wenn ein Diagnostizieren, dass sich die Batterie in einem abnormalen Zustand befindet, Batteriedaten, welche in dem temporären Speicher (10) gespeichert worden sind, zu einer Zeit, zu welcher diagnostiziert worden ist, dass sich die Batterie in dem abnormalen Zustand befindet, und Batteriedaten zu erhalten, welche nach einem Verstreichen eines spezifischen Zeitraums in dem temporären Speicher (10) gespeichert worden sind, und die Batteriedaten zu klassifizieren und in der Mehrzahl von Speichern (20) zu speichern.

5. Batteriedatenverwaltungsvorrichtung nach Anspruch 1, wobei der Speicher (211) die Batteriedaten in regulären Intervallen in einer kreisförmigen Warteschleife des temporären Speichers (10) speichert.

6. Batteriedatenverwaltungsvorrichtung nach Anspruch 1, wobei die Batteriedaten wenigstens eines aus Spannung, Strom, Temperatur und Diagnoseinformationen der Batterie umfassen.

7. Betriebsverfahren einer Batteriedatenverwaltungsvorrichtung (200), wobei das Betriebsverfahren umfasst:
temporär Speichern von Batteriedaten (S101);
Bestimmen, ob die Batterie abnormal ist, auf Grundlage der Batteriedaten (S102);
Bestimmen eines Abnormalitätsgrads der Batterie auf Grundlage davon, ob die Batterie abnormal ist (S103); und
Klassifizieren und Speichern der Batteriedaten in einer Mehrzahl von Speichern (20) auf Grundlage des Abnormalitätsgrads der Batterie (S104),
**dadurch gekennzeichnet, dass** das Bestimmen des Abnormalitätsgrads der Batterie auf Grundlage davon, ob die Batterie abnormal ist, ein Bestimmen umfasst, ob die Batterie einem Abnormalitätsgrad entspricht, in einer absteigenden Reihenfolge eines Risikograds des Abnormalitätsgrads.

8. Betriebsverfahren nach Anspruch 7, wobei das Bestimmen des Abnormalitätsgrads der Batterie auf Grundlage davon, ob die Batterie abnormal ist, ein Speichern der Batteriedaten in jeglichem einer Mehrzahl von Speichern (20) umfasst, welcher dem Abnormalitätsgrad der Batterie entspricht.

9. Betriebsverfahren nach Anspruch 7, wobei das Klassifizieren und Speichern der Batteriedaten in der Mehrzahl von Speichern (20) auf Grundlage des Abnormalitätsgrads der Batterie ein Speichern, auf Grundlage von Prioritäten einer Mehrzahl von Speicherbereichen von jeglichem der Mehrzahl von Speichern, der Batteriedaten in jeglichem der Mehrzahl von Speicherbereichen umfasst.

10. Betriebsverfahren nach Anspruch 7, wobei das temporäre Speichern der Batteriedaten ein Erhalten, wenn ein Diagnostizieren, dass sich die Batterie in einem abnormalen Zustand befindet, von Batteriedaten, welche in dem temporären Speicher (10) gespeichert worden sind, zu einer Zeit, zu welcher diagnostiziert worden ist, dass sich die Batterie in dem abnormalen Zustand befindet, und von Batteriedaten, welche nach einem Verstreichen eines spezifischen Zeitraums in dem temporären Speicher gespeichert worden sind, und ein Klassifizieren und Speichern der Batteriedaten in der Mehrzahl von Speichern (20) umfasst.

11. Betriebsverfahren nach Anspruch 7, wobei das temporäre Speichern der Batteriedaten ein Speichern der Batteriedaten in regulären Intervallen in einer kreisförmigen Warteschleife des temporären Speichers (10) umfasst.

## Revendications

1. Appareil de gestion de données de batterie (200) comprenant :
un dispositif de commande (212) configuré pour déterminer si une batterie est anormale sur la base de données de batterie, déterminer un niveau d'anomalie de la batterie sur la base de si la batterie est anormale, et classer et stocker les données de batterie dans une pluralité d'espaces de stockage (20), sur la base du niveau d'anomalie de la batterie ; et
une mémoire (211) comprenant la pluralité d'espaces de stockage (20) et un espace de stockage temporaire (10) stockant temporairement les données de batterie,
**caractérisé en ce que** le dispositif de commande (212) est en outre configuré pour déterminer si la batterie correspond à un niveau anormal dans l'ordre décroissant d'un niveau de risque du niveau d'anomalie.

2. Appareil de gestion de données de batterie selon la revendication 1, dans lequel le dispositif de commande (212) est en outre configuré pour stocker les données de batterie dans l'un quelconque de la pluralité d'espaces de stockage (10), qui correspondent au niveau d'anomalie de la batterie.

3. Appareil de gestion de données de batterie selon la revendication 1, dans lequel le dispositif de commande (212) est en outre configuré pour, sur la base de priorités d'une pluralité de régions de stockage de l'un quelconque de la pluralité d'espaces de stockage (20), stocker les données de batterie dans l'une quelconque de la pluralité de régions de stockage.

4. Appareil de gestion de données de batterie selon la revendication 1, dans lequel le dispositif de commande (212) est en outre configuré pour, lorsqu'il est diagnostiqué que la batterie est dans un état anormal, obtenir des données de batterie stockées dans l'espace de stockage temporaire (10) à un moment où la batterie est diagnostiquée comme étant dans l'état anormal, et des données de batterie stockées dans l'espace de stockage temporaire (10) après l'écoulement d'une période spécifique, et classer et stocker les données de batterie dans la pluralité d'espaces de stockage (20).

5. Appareil de gestion de données de batterie selon la revendication 1, dans lequel la mémoire (211) stocke les données de batterie à intervalles réguliers dans une file d'attente circulaire de l'espace de stockage temporaire (10).

6. Appareil de gestion de données de batterie selon la revendication 1, dans lequel les données de batterie comprennent au moins l'une quelconque parmi des informations de tension, de courant, de température et de diagnostic de la batterie.

7. Procédé de fonctionnement d'un appareil de gestion de données de batterie (200), le procédé de fonctionnement comprenant :
le stockage de manière temporaire de données de batterie (S101) ;
le fait de déterminer si la batterie est anormale, sur la base des données de batterie (S102) ;
la détermination d'un niveau anormal de la batterie sur la base de si la batterie est anormale (S103) ; et
le classement et le stockage des données de batterie dans une pluralité d'espaces de stockage (20), sur la base du niveau anormal de la batterie (S104),
**caractérisé en ce que** la détermination du niveau anormal de la batterie, sur la base de si la batterie est anormale, comprend le fait de déterminer si la batterie correspond à un niveau anormal dans l'ordre décroissant d'un niveau de risque du niveau d'anomalie.

8. Procédé de fonctionnement selon la revendication 7, dans lequel la détermination du niveau anormal de la batterie sur la base de si la batterie est anormale comprend le stockage des données de batterie dans l'un quelconque de la pluralité d'espaces de stockage (20), qui correspondent au niveau d'anomalie de la batterie.

9. Procédé de fonctionnement selon la revendication 7, dans lequel le classement et le stockage des données de batterie dans la pluralité d'espaces de stockage (20), sur la base du niveau anormal de la batterie, comprennent, sur la base de priorités d'une pluralité de régions de stockage de l'un quelconque de la pluralité d'espaces de stockage, le stockage des données de batterie dans l'une quelconque de la pluralité de régions de stockage.

10. Procédé de fonctionnement selon la revendication 7, dans lequel le stockage de manière temporaire des données de batterie comprend, lorsqu'il est diagnostiqué que la batterie est dans un état anormal, l'obtention de données de batterie stockées dans l'espace de stockage temporaire (10) à un moment où la batterie est diagnostiquée comme étant dans l'état anormal, et de données de batterie stockées dans l'espace de stockage temporaire après l'écoulement d'une période spécifique, et le classement et le stockage des données de batterie dans la pluralité d'espaces de stockage (20).

11. Procédé de fonctionnement selon la revendication 7, dans lequel le stockage de manière temporaire des données de batterie comprend le stockage des données de batterie à intervalles réguliers dans une file d'attente circulaire de l'espace de stockage temporaire (10).
